# EUROPÄISCHE PATENTSCHRIFT

(11) **EP 3 399 375 B1**
(45) Veröffentlichungstag und Bekanntmachung des Hinweises auf die Patenterteilung: **13.11.2019**
(21) Anmeldenummer: 17169687.5
(22) Anmeldetag: 05.05.2017
(51) Int. Cl.: G05B 19/042, G06F 9/445

(54) **VERFAHREN ZUR KONFIGURATION VON STEUERGERÄTEN**
METHOD FOR CONFIGURING CONTROL DEVICES
PROCÉDÉ DE CONFIGURATION D'APPAREILS DE COMMANDE

(43) Veröffentlichungstag der Anmeldung: 07.11.2018
(73) Patentinhaber: dSPACE digital signal processing and control engineering GmbH, 33102 Paderborn (DE)
(72) Erfinder: Stolpe, Ralf, 33161 Hövelhof (DE); Heier, Michael, 33758 Schloß Holte-Stukenbrock (DE); Hölker, Jürgen, 59558 Lippstadt (DE)

(56) Entgegenhaltungen:
- WO-A1-2014/023335
- DE-A1-102011 121 879
- US-B2- 8 418 139

## Beschreibung

Die Erfindung betrifft ein Verfahren zur Konfiguration von Steuergeräten gemäß dem Oberbegriff des Patentanspruchs 1.

Steuergeräte werden zur Steuerung oder Regelung in vielen unterschiedlichen Szenarien eingesetzt, beispielsweise in Fahrzeugen oder in Flugzeugen. Steuergeräte kommunizieren über Busse oder Netzwerke miteinander und über Sensoren und Aktoren mit ihrer Außenwelt. Wann welche Information von einem Steuergerät verarbeitet wird, wird vom Entwickler des Steuergerätes während der Entwicklung festgelegt.

Um die ihnen per Software zugewiesenen Funktionen durchführen zu können, müssen Steuergeräte konfiguriert d.h. die erforderlichen Funktionen müssen implementiert und parametriert werden. Diese Aufgabe kann äußerst aufwendig und komplex sein.

In der US 8,418,139 B2 wird ein Verfahren beschrieben zur Konfiguration und Aktualisierung von Initialisierungsparametern für eine Anwendungssoftware, die auf einem Server ausgeführt wird, welcher mit Entwicklungscomputern verbunden ist. Wenn die Anwendungssoftware in einem Produktionsmodus betrieben wird, werden ausschließlich Initialisierungsparameter aus einer Datei mit vorgegebenen Werten verwendet. Im Testmodus überprüft das System, ob eine Änderung der Initialisierungsparameter erfolgt ist und stößt gegebenenfalls eine erneute Initialisierung an. Es ist jedoch nicht dargestellt, wie solche Änderungen auf effiziente Weise konfiguriert werden können.

DE102011121879A12 stellt ein Steuergerät mit einer Speichereinrichtung und einer Parseeinrichtung vor, die ermöglichen, das Steuergerät nach einem Softwarewechsel mit den alten, zuvor in der Speichereinrichtung gespeicherten Parametern neu zu konfigurieren.

Zur Konfiguration der Buskommunikation zwischen Steuergeräten und/oder entsprechenden Testsystemen ist aus dem Stand der Technik das Programm "Bus Manager" der Firma dSPACE bekannt (https://www.dspace.com/shared/data/pdf/2016/50-53_Kommunikation_ist_alles_de.pdf). In dem Programm kann einem Steuergerät eine oder mehrere Nachrichten zugeordnet werden,
die von diesem versendet oder empfangen werden können. Jede Nachricht besteht wieder aus einem oder mehreren Signalen. Unter einem Signal wird hier eine logische Informationseinheit verstanden, dies ist nicht zwingend eine physikalische Informationseinheit. Mehrere Signale können zu größeren Einheiten zusammengefasst werden, diese werden als Protokoll Data Units bezeichnet, in Kurzform PDU genannt. Mit dem Bus Manager ist es möglich Eigenschaften von Signalen, PDUs, Nachrichten und Steuergeräten individuell zu verstellen.

Im Bus Manager können verschiedene Funktionalitäten eines Steuergerätes, einer Busnachricht, einer PDU oder eines Signals angezeigt werden. Diese Funktionalitäten können ausgewählt und die zugehörigen Parameter angezeigt werden. Diese Parameter können dann einzeln verstellt werden. Wenn gleichartige Funktionalitäten an verschiedenen Stellen neu parametriert werden sollen, werden die jeweiligen Funktionalitäten vom Nutzer pro Element ausgewählt und die Parameter der einzelnen Funktionalitäten jeweils neu eingestellt. Diese Form der elementbasierten Parametrierung ist aufwendig und fehleranfällig.

In der WO 2014 023335 A1 werden zur Konfiguration eines intelligenten elektronischen Gerätes mittels einer Konfigurationsdatenbank Basis-Konfigurationen und Konfigurationen mit davon abweichenden Parameterwerten bereitgestellt. Der Anwender kann durch Auswählen einer Kombination der so vorgegebenen Parameter auf vereinfachte Weise eine gewünschte Zielkonfiguration für bestimmte Funktionen des Gerätes erstellen. In dieser Druckschrift wird jedoch nicht das Problem behandelt, dass mehrere Instanzen derselben Funktion vorliegen und wie bei einer Änderung der Parameterwerte der Zielkonfiguration eine mühsame Neukonfiguration für jede Instanz vermieden werden kann.

Vor diesem Hintergrund besteht die Aufgabe der Erfindung darin, ein Verfahren anzugeben, das den Stand der Technik weiterbildet.

Die Aufgabe wird durch ein Verfahren mit den Merkmalen des Patentanspruchs 1 gelöst. Vorteilhafte Ausgestaltungen der Erfindung sind Gegenstand von abhängigen Unteransprüchen.

Hierbei wird unter einer Funktionalitätsklasse die Kombination von einer Funktion und einem oder mehreren Parametern verstanden. Die Funktion beschreibt einen Algorithmus oder eine Durchführungsvorschrift, die von dem Steuergerät ausgeführt werden soll, insbesondere eine Durchführungsvorschrift zur Erstellung von Nachrichten, wobei die Nachrichten vom konfigurierten Steuergerät über einen Bus oder ein Netzwerk versendet werden. Ein Beispiel für eine Funktionalitätsklasse ist ein sogenannter Alive-Counter. Wird ein Signal als Alive-Counter definiert, so wird ihr Wert mit jeder Versendung der zugehörigen Nachricht gemäß der Funktionalität verändert. Die Funktion kann hier beispielsweise sein, dass der Wert des Signals bei der Initialisierung auf einen Startwert gesetzt wird, bei jeder Versendung der zugehörigen Nachricht um einen Inkrementwert erhöht wird und bei erreichen einen Stoppwertes wieder auf den Startwert gesetzt wird. Startwert, Inkrementwert und Stoppwert sind hierbei drei Parameter der Funktionalität.

Bei Funktionalitäten mit einer Vielzahl von Parametern wird bei der Zuordnung der Funktionalität zu einer Default-Kategorie für jeden Parameter der für den jeweiligen Parameter vorbestimmte Wert der Default-Kategorie übernommen.

Zur Konfiguration des Steuergerätes wird aus der erstellten Konfiguration ein Programmcode oder zumindest ein Teil eines Programmcodes für das Steuergerät erzeugt und der Programmcode auf das Steuergerät geladen. Im Falle eines simulierten Steuergerätes wird der Programmcode von einem Simulator ausgeführt. Im Betrieb wird das Steuergerät die konfigurierten Funktionalitäten ausführen. In einer Ausführungsform können Parameter einer Funktionalität während der Ausführung des Programmcodes auf dem Steuergerät oder dem Simulator verändert werden. Eine Veränderung der Parameter kann aus dem Programmcode heraus erfolgen, aus einem anderen auf dem Simulator oder Steuergerät ausgeführten Programm erfolgen oder Parameter im Speicher des Simulators oder Steuergerätes können von außen überschrieben werden.

Eine Funktionalität ist eine Instanz einer Funktionalitätsklasse. Eine Funktionalität wird einem Signal, einer PDU, einer Nachricht oder einem Steuergerät zugeordnet. Ein Signal wird einer PDU zugeordnet. Eine PDU wird einer Nachricht zugeordnet. Eine Nachricht wird einem Steuergerät zugeordnet. Eine Funktionalität wird also direkt oder indirekt einem Steuergerät zugeordnet. Das konfigurierte Steuergerät führt die entsprechende Funktion mit den eingestellten Parameterwerten aus.

Ein Vorteil des erfindungsgemäßen Verfahrens ist es, dass die Funktionalitäten der Steuergeräte wesentlich komfortabler und steuergeräteübergreifend konfiguriert werden können. Durch Zuordnung einer Funktionalität zu einer Default-Kategorie werden der oder die vorbestimmten Werte für die Parameter der Funktionalität übernommen. Zur Umkonfiguration einer Funktionalität ist lediglich die Zuordnung zu einer anderen Default-Kategorie notwendig. Das Umkonfigurieren der einzelnen Parameterwerte geschieht automatisiert durch eine, das erfindungsgemäße Verfahren ausführende, Datenverarbeitungseinrichtung. Durch Ändern der vorbestimmten Werte einer Default-Kategorie werden die Parameterwerte aller der Default-Kategorie zugeordneten Funktionalitäten geändert. Auf diese Weise kann eine Gruppe von Funktionalitäten gleichzeitig umkonfiguriert werden.

In einer bevorzugten Ausführungsform weist die erste Funktionalitätsklasse eine zweite Default-Kategorie auf, wobei für die zweite Default-Kategorie für den mindestens einen ersten Parameter ein zweiter vorbestimmter Wert hinterlegt ist und bei der Zuordnung der Funktionalität zu der zweiten Default-Kategorie für den mindestens einen ersten Parameter der zweite vorbestimmte Wert übernommen wird, wobei bei einer Änderung des zweiten vorbestimmten Werts des ersten Parameters der zweiten Default-Kategorie die Änderung für alle bereits der zweiten Default-Kategorie zugeordneten Funktionalitäten übernommen wird.

Ein Vorteil der Ausführungsform ist, dass eine Vielzahl von Funktionalitäten komfortabel mit unterschiedlichen Parametersätzen konfiguriert werden können. Die zweite Default-Kategorie hat im Allgemeinen die gleichen Eigenschaften wie die erste Default-Kategorie.

In einer Ausführungsform sind die Steuergeräte an ein gemeinsames Netzwerk angeschlossen sind.

Ein solches Netzwerk kann bspw. ein FlexRay- oder Ethernet-Netzwerk sein. Alternativ können die Steuergeräte an einen Bus, bspw. einen CAN- oder LIN-Bus angeschlossen sein. Über das gemeinsame Netzwerk oder den gemeinsamen Bus können die Steuergeräte Nachrichten austauschen.

In einer Ausführungsform ist es bevorzugt, dass die Funktionalität aus einer Netzwerkbeschreibungsdatei ausgelesen wird.

Eine solche Netzwerkbeschreibungsdatei kann beispielsweise eine Datei nach dem AUTOSAR-Standard oder eine FIBEX-Datei sein. In einer Netzwerkbeschreibungsdatei, der sogenannten Bus-Kommunikationsmatrix, wird ein Kommunikationsnetzwerk beschrieben. Es ist dort unter anderem hinterlegt welche Steuergeräte welche Funktionen berechnen und über welche Bussysteme, über welche Pakete und Signale sie miteinander kommunizieren. Durch das Auslesen aus einer Netzwerkbeschreibungsdatei können Funktionalitäten sehr leicht in das Konfigurationsverfahren eingebracht werden.

Alternativ können Funktionalitäten auch durch ein, das Konfigurationsverfahren ausführendes, Computerprogramm vorgegeben werden oder während des Konfigurationsverfahrens neu erstellt werden. Dies ist vorteilhaft für Funktionalitäten die typischerweise nicht in Netzwerkbeschreibungsdateien aufgenommen werden.

In einer Weiterbildung werden die vorbestimmten Werte aus einer Netzwerkbeschreibungsdatei ausgelesen.

Durch das Auslesen aus einer Netzwerkbeschreibungsdatei können die vorgegebenen Werte sehr leicht in das Konfigurationsverfahren eingebracht werden. Die Werte können in der Netzwerkbeschreibungsdatei bereits der Funktionalität zugeordnet sein. Alternativ können die vorgegebenen Werte auch durch ein, das Konfigurationsverfahren ausführendes, Computerprogramm vorgegeben werden.

In einer bevorzugten Ausführungsform wird die Funktionalität durch die Zuordnung zu einer Default-Kategorie um eine zusätzliche Funktion und/oder einen zusätzlichen Parameter erweitert.

Die Erweiterung von Funktionalitäten ist vorteilhaft für Funktionen, die die Simulation von Fehlverhalten und Manipulationsmöglichkeiten ermöglichen. Es wird damit eine neue Funktionalität auf Basis einer vorhandenen Funktionalität konfiguriert. Ein Beispiel für eine solche erweiterte Funktionalität ist der zeitweise Ausfall eines Alive-Counters. Dazu besitzt die erweiterte Funktionalität einen Parameter für das Aktivieren des Ausfalls. Der Parameter für das Aktivieren kann beispielsweise vom Typ einer booleschen Variablen sein. Zusätzlich kann die Funktionalität einen Parameter umfassen über den der Wert für die Anzahl der Ausfälle gesetzt werden kann. Mit einer so erweiterten Funktionalität kann der Umgang eines realen Steuergerätes mit einem stehenden Alive Counter getestet werden.

In einer anderen Ausführungsform wird eine der ersten Funktionalitätsklasse zugeordnete dritte Funktionalität automatisch der ersten Default-Kategorie zugeordnet, wenn nach einer individuellen Änderung eines Werts eines Parameters der dritten Funktionalität die Werte aller Parameter der dritten Funktionalität mit den jeweiligen vorbestimmten Werten der ersten Default-Kategorie übereinstimmen.

Die Zuordnung zur ersten Default-Kategorie wird also anhand eines Vergleichs der Werte der Parameter mit den vorbestimmten Werten vorgenommen und die Funktionalität der Default-Kategorie zugeordnet. Es können also sowohl die Werte der Parameter durch Zuordnung der Funktionalität zur Default-Kategorie festgelegt werden als auch über die Eingabe der gleichen Werte die Zuordnung der Funktionalität zur Default-Kategorie festgelegt werden.

Gemäß einer anderen Weiterbildung wird eine vierte Funktionalität automatisch der Else-Kategorie zugeordnet, wenn ein Werts eines Parameters der vierten Funktionalität individuell geändert wird und keine Default-Kategorie vorhanden ist, deren vorbestimmte Werte den Parameterwerten der vierten Funktionalität entsprechen.

Die Else-Kategorie stellt ein Sammelbecken für diejenigen Funktionalitäten dar, die keiner Default-Kategorie zugeordnet sind. Die Else-Kategorie enthält keine vorbestimmten Werte für Parameter. Dadurch wird jede Funktionalität einer Kategorie zugeordnet, entweder einer Default-Kategorie oder der Else-Kategorie. Dies verbessert die Strukturierung der Funktionalitäten.

In einer Weiterbildung wird eine dritte Default-Kategorie aus einer zweiten Funktionalität der ersten Funktionalitätsklasse erzeugt, indem die zweite Funktionalität ausgewählt wird und der Wert des mindestens einen Parameters der zweiten Funktionalität als vorbestimmter Wert für die dritte Default-Kategorie hinterlegt wird.

Eine zweite Funktionalität wird zur Grundlage einer dritten Default-Kategorie. Die zweite Funktionalität ist dabei bevorzugt der Else-Kategorie zugeordnet und wird nach der Erstellung der dritten Default-Kategorie der dritten Default-Kategorie zugeordnet. Die Werte der Parameter der zweiten Funktionalität werden dabei zu den vorbestimmten Werten der dritten Default-Kategorie. Die vorbestimmten Werte können verändert oder entfernt werden. Für Funktionalitäten der ersten Funktionsklasse, die der dritten Default-Kategorie zugeordnet werden, werden die vorbestimmten Werte für die Parameter bei der Zuordnung übernommen.

Vorteilhaft an der Ausführungsform ist, dass weitere Funktionalitäten leicht auf die Parameterwerte der zweiten Funktionalität konfiguriert werden können, aus der die dritte Default-Kategorie erzeugt wurde.

In einer Ausführungsform wird die Funktionalität einer von dem zugeordneten Steuergerät zu versendenden Nachricht zugeordnet.

Das Zuordnen der Funktionalität zu einer Nachricht ist insbesondere vorteilhaft, wenn die Funktionalität eine Eigenschaft der Nachricht beschreibt. Die konfigurierte Nachricht wird von dem Steuergerät über einen an das Steuergerät angeschlossenen Bus oder ein Netzwerk versendet. Eine solche Eigenschaft der Nachricht kann beispielsweise eine End-to-End Protection sein. End-to-End Protection bedeutet hier, dass die Nachricht über einen berechneten CRC Wert unter Berücksichtigung eines Alive Counters und einer Data ID bei der Übertragung auf dem Bus abgesichert wird, so dass Übertragungsfehler auf der Empfängerseite detektiert werden können.

In einer anderen Ausführungsform wird die Funktionalität einem von dem zugeordneten Steuergerät zu versendenden Signal zugeordnet.

Das Zuordnen der Funktionalität zu einem Signal ist insbesondere vorteilhaft, wenn die Funktionalität eine Eigenschaft des Signals, bspw. einen Defaultwert, beschreibt. Ein Signal ist typischerweise Teil einer Nachricht, d.h. eine Nachricht wird aus einem oder mehreren Signalen zusammengesetzt. Zusätzlich zu den Signalen enthält eine Nachricht typischerweise Verwaltungsinformationen, bspw. eine ID, einen Empfänger und/oder einen Absender.

In einer vorteilhaften Ausführungsform umfasst die erste Funktionalität einen zweiten Parameter, wobei in der ersten Default-Kategorie für den zweiten Parameter kein vorbestimmter Wert hinterlegt ist, wobei der Wert des zweiten Parameters bei der Zuordnung der Funktionalität zur ersten Default-Kategorie unverändert bleibt.

Vorbestimmte Werte nur für einen Teil der Parameter der Funktionalität in der Default-Kategorie zu hinterlegen ist vorteilhaft, wenn ein Teil der Paramater individuell eingestellt werden soll, ein anderer Teil der Parameter jedoch für eine Vielzahl von Funktionalitäten identisch sein soll. Erfindungsgemäß können dann die Parameter mit identischen Werten durch Zuordnen der Funktionalitäten zur gleichen Default-Kategorie eingestellt werden. Die Parameter ohne vorbestimmte Werte können individuell eingestellt werden, ohne dass die Zuordnung zur Default-Kategorie gelöst wird. Wird in der Default-Kategorie ein vorbestimmter Wert für einen Parameter gesetzt, für den noch kein vorbestimmter Wert enthalten war, so wird der neu gesetzte vorbestimmte Wert für die entsprechenden Parameter aller der Default-Kategorie zugeordneten Funktionalitäten übernommen.

Des Weiteren umfasst die Erfindung eine Datenverarbeitungseinrichtung mit einer Prozessoreinheit, wobei die Datenverarbeitungseinrichtung zur Durchführung des erfindungsgemäßen Verfahrens ausgeführt ist.

Zur Erfindung gehört auch ein Computerprogrammprodukt mit Computer-implementierten Anweisungen, das nach dem Laden und Ausführen in einer geeigneten Datenverarbeitungseinrichtung die Schritte des erfindungsgemäßen Verfahrens ausführt.

Die Erfindung umfasst auch ein Digitales Speichermedium mit elektronisch auslesbaren Steuersignalen, die so mit einer programmierbaren Datenverarbeitungseinrichtung zusammenwirken können, dass das erfindungsgemäße Verfahren auf der Datenverarbeitungseinrichtung ausgeführt wird.

Die Erfindung wird nachfolgend unter Bezugnahme auf die Zeichnungen näher erläutert. Hierbei werden gleichartige Teile mit identischen Bezeichnungen beschriftet. In diesem Beispiel werden Signale direkt Nachrichten zugeordnet. Es versteht sich, dass Signale wie oben beschrieben auch PDUs zugeordnet werden können und die PDUs dann Nachrichten zugeordnet werden. Darin zeigt:
- Figur 1: eine schematische Ansicht einer Zuordnung von Funktionalitäten zu Signalen,
- Figur 2: eine schematische Ansicht von Default-Kategorien einer Funktionalitätsklasse,
- Figur 3: eine schematische Ansicht einer Zuordnung von Funktionalitäten zu Signalen mittels Kategorien,
- Figur 4: eine weitere schematische Ansicht von Default-Kategorien einer Funktionalitätsklasse,
- Figur 5: eine weitere schematische Ansicht einer Zuordnung von Funktionalitäten zu Signalen mittels Kategorien.

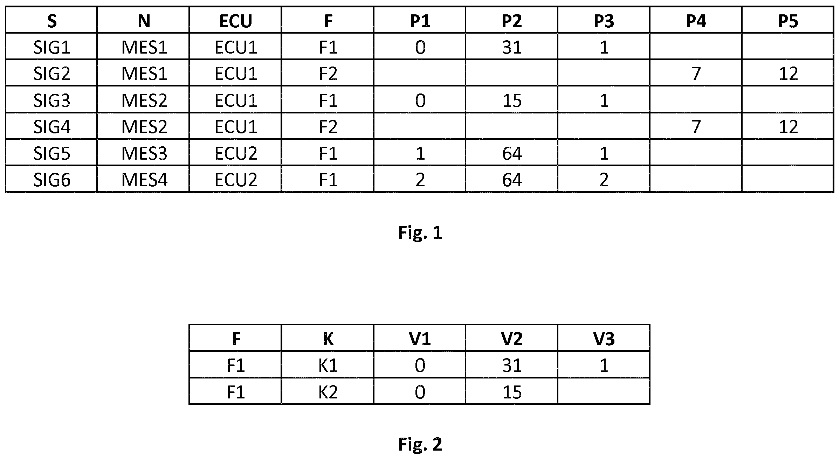

Die Abbildung der Figur 1 zeigt eine schematische Ansicht einer Zuordnung von Funktionalitäten zu Signalen. In dem Beispiel von Figur 1 sind sieben Signalen SIG1, SIG2, SIG3, SIG4, SIG5, SIG6 jeweils eine Funktionalität zugeordnet. Jede Zeile, abgesehen von der ersten Zeile, zeigt dabei die Eigenschaften einer Funktionalität. Dem ersten Signal SIG1, dem dritten Signal SIG3, dem fünften Signal SIG5 und dem sechsten Signal SIG6 ist jeweils eine Funktionalität einer ersten Funktionsklasse F1 zugeordnet. Dem zweiten Signal SIG2 und dem vierten Signal SIG4 ist jeweils eine Funktionalität der zweiten Funktionsklasse F2 zugeordnet.

Die erste Funktionsklasse F1 umfasst drei Parameter P1, P2, P3. Die zweite Funktionsklasse umfasst einen vierten Parameter P4 und einen fünften Parameter P5. Die Werte der Parameter sind für jede Funktionalität individuell eingestellt. Die Werte der Parameter sind in diesem Beispiel ganzzahlig. Parameter von Funktionsklassen können auch für andere Werttypen ausgelegt. Beispiele für Werttypen sind Gleitkommazahlen, boolesche Variablen und Zeichenketten.

In diesem Beispiel ist die erste Funktionsklasse F1 die Klasse der Alive Counter. Der erste Parameter P1 ist ein Startwert, der zweite Parameter P2 ist ein Stoppwert und der dritte Parameter P3 ist ein Inkementwert.

Das erste Signal SIG1 und das zweite Signal SIG2 sind einer ersten Nachricht MES1 zugeordnet. Das dritte Signal SIG3 und das vierte Signal SIG4 sind einer zweiten Nachricht MES2 zugeordnet. Das fünfte Signal SIG5 und das sechste Signal SIG6 sind einer dritten Nachricht MES3 zugeordnet. Die erste Nachricht MES1 und die zweite Nachricht MES2 sind einem ersten Steuergerät ECU1 zugeordnet. Die dritte Nachricht MES3 ist einem zweiten Steuergerät ECU2 zugeordnet.

In der Abbildung der Figur 2 ist eine schematische Ansicht von Default-Kategorien einer Funktionalitätsklasse dargestellt. Die Funktionsklasse F1 hat zwei Default-Kategorien K1, K2. Jede Default-kategorie hat drei vorbestimmte Werte V1, V2, V3 für die drei Parameter P1, P2, P3 der Funktionalitäten der ersten Funktionsklasse F1. Wird eine Funktionalität der ersten Default-Kategorie K1 zugeordnet, so wird für den ersten ParameterP1 der erste vorbestimmte Wert V1 übernommen, für den zweiten Parameter P2 der zweite vorbestimmte Wert V2 übernommen und für den Wert des dritten Parameters P3 der dritte vorbestimmte Wert V3 übernommen. Für die zweite Default-Kategorie K2 ist der dritte vorbestimmte Wert V3 nicht vergeben. Wird eine Funktionalität der zweiten Default-Kategorie K2 zugeordnet, so wird für den ersten Parameter P1 der erste vorbestimmte Wert V1 übernommen, für den zweiten Parameter P2 der zweite vorbestimmte Wert V2 übernommen und der Wert des dritten Parameters P3 bleibt unverändert. Der Wert des dritten Parameters P3 kann individuell verändert werden, ohne die Zuordnung der Funktionalität zur zweiten Default-Kategorie zu brechen.

Neben den Default-Kategorien existiert noch eine ELSE-Kategorie. Die ELSE-Kategorie hat keine vorbestimmten Werte. Funktionalitäten einer Funktionsklasse, die keiner Default-Kategorie zugeordnet sind, werden automatisch der ELSE-Kategorie zugeordnet.

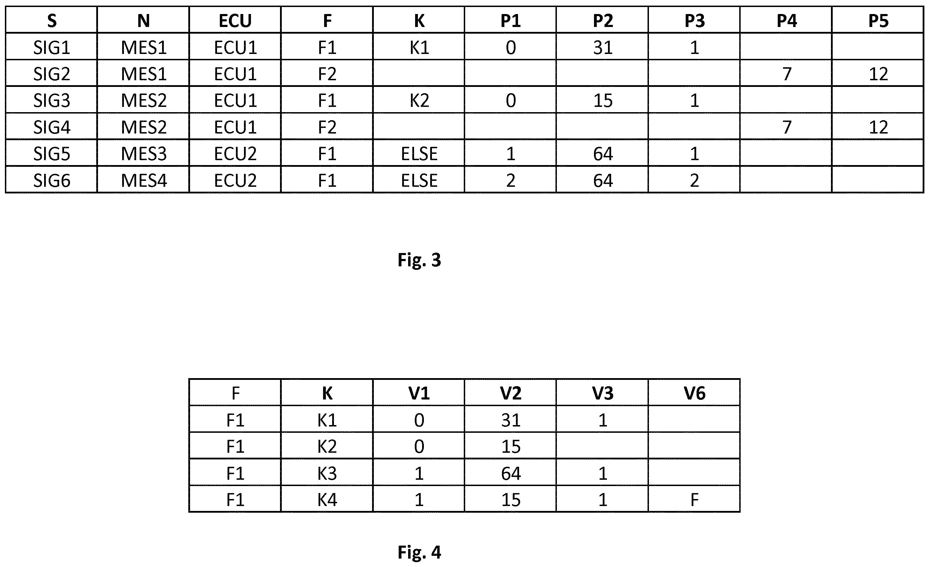

Figur 3 zeigt eine schematische Ansicht einer Zuordnung von Funktionalitäten zu Signalen mittels Kategorien. Im Folgenden werden nur die Unterschiede zu der Abbildung der Figur 1 erläutert. Die Funktionalitäten der ersten Funktionsklasse sind jeweils eine Kategorie zugeordnet. Die dem ersten Signal SIG1 zugeordnet Funktionalität ist der ersten Default-Kategorie K1 zugeordnet. Die dem dritten Signal SIG3 zugeordnet Funktionalität ist der zweiten Default-Kategorie K2 zugeordnet. Die dem fünften Signal SIG5 zugeordnet Funktionalität und die dem sechsten Signal SIG6 zugeordneten Funktionalitäten sind der der ELSE-Kategorie ELSE zugeordnet. Das zweite Signal SIG2 und das vierte Signal SIG4 sind der zweiten Funktionsklasse F2 zugeordnet und können daher keiner Kategorie der ersten Funktionsklasse F1 zugeordnet werden.

Figur 4 zeigt eine weitere schematische Ansicht von Default-Kategorien einer Funktionalitätsklasse. Im Folgenden werden nur die Unterschiede zu der Abbildung der Figur 2 erläutert. Aus den Parameterwerten der dem fünften Signal SIG5 aus Figur 3 zugeordneten Funktion wird ein dritte Default-Kategorie K3 erstellt. Die Werte der drei Parameter P1, P2, P3 werden zu den drei vorbestimmten WertenV1, V2, V3 der dritten Default-Kategorie K3. Es wird eine vierte Default-Kategorie K4 erstellt. Die Funktionalität der vierten Default-Kategorie K4 ist im Vergleich zu den drei anderen Default-Kategorien K1, K2, K3 erweitert. Die Funktionalität der vierten Default-Kategorie K4 gehört zur ersten Funktionsklasse F1 und umfasst neben den drei bereits beschriebenen vorbestimmten Werten V1, V2, V3 einen vierten vorbestimmten Wert V6. Der vierte vorbestimmte Wert V6 ist vom Typ einer booleschen Variablen und in diesem Beispiel mit dem Wert Falsch belegt. Die neue Funktionalität der vierten Default-Kategorie ermöglicht zur Fehlersimulation das Ausschalten des Alive-Counters zur Laufzeit. Der vierte vorbestimmte Wert V6 bestimmt dabei, ob der Alive-Counter zu Beginn eingeschaltet oder ausgeschaltet ist.

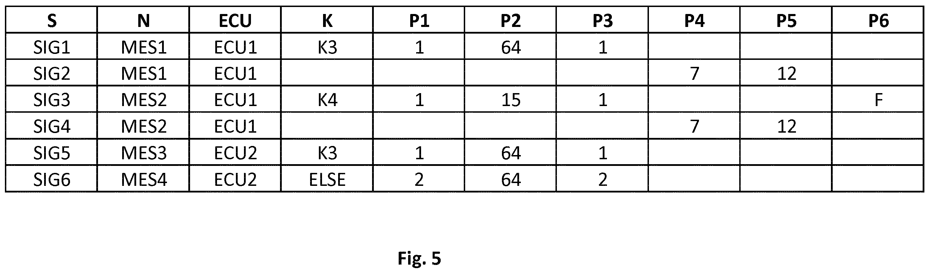

Figur 5 zeigt eine schematische Ansicht einer Zuordnung von Funktionalitäten zu Signalen mittels Kategorien. Im Folgenden werden nur die Unterschiede zu der Abbildung der Figur 3 erläutert. Die dem ersten Signal SIG1 zugordnete Funktionalität wird der dritten Default-Kategorie K3 zugeordnet. Durch die Zuordnung wird der Wert des ersten Parameters P1 auf den Wert des ersten vorbestimmten Wertes V1 der dritten Default-Kategorie K3 gesetzt. Ebenso wird durch die Zuordnung der Wert des zweiten Parameters P2 auf den Wert des zweiten vorbestimmten Wertes V2 der dritten Default-Kategorie K3 und der Wert des dritten Parameters P3 auf den Wert des dritten vorbestimmten Wertes V3 der dritten Default-Kategorie K3 gesetzt. Die drei Parameterwerte P1, P2, P3 der dem fünften Signal SIG5 zugeordneten Funktionalität stimmen mit den drei vorbestimmten Werten V1, V2, V3 der dritten Default-Kategorie K3 überein, wodurch die Funktionalität automatisch der dritten Default-Kategorie zugeordnet wird. Die dem dritten Signal SIG3 zugeordnete Funktionalität wird der vierten Default-Kategorie K4 zugeordnet, wodurch die Funktionalität um die Möglichkeit der Aktivierung des Ausfalls erweitert wird und einen sechsten Parameter P6 erhält. Der Wert des sechsten Parameters P6 wird durch die Zuordnung der Funktionalität zur vierten Default-Kategorie auf den vierten vorbestimmten Wert V6 der vierten Default-Kategorie K4 gesetzt. Wird der Wert des sechsten Parameters P6 zur Laufzeit auf den Wert "Wahr" gesetzt, so wird der Ausfall des Alive-Counters aktiviert und der Alive-Counter bei folgenden Versendungen durch das Steuergerät nicht aktualisiert.

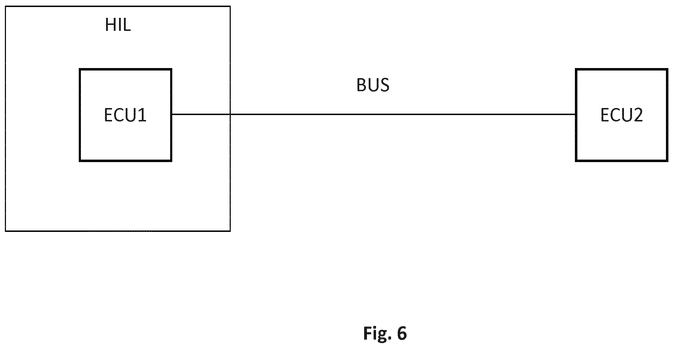

Figur 6 zeigt eine schematische Ansicht von zwei konfigurierten Steuergeräten. Aus den konfigurierten Funktionalitäten wird dann der Programmcode oder zumindest ein Teil des Programmcodes für die Steuergeräte ECU1, ECU2 erstellt. Der Programmcode wird dann auf das jeweilige Steuergerät übertragen. Das erste Steuergerät ECU1 ist in diesem Beispiel ein simuliertes Steuergerät. Ein Simulator HIL führt den für das erste Steuergerät ECU1 erstellten Programmcode aus. Das erste Steuergerät ECU1 ist über eine Signalleitung BUS mit dem zweiten Steuergerät ECU2 verbunden. Das zweite Steuergerät ECU2 führt den für das zweite Steuergerät ECU2 erstellten Programmcode aus. Das erste Steuergerät ECU1 erzeugt die erste Nachricht MES1 mit dem ersten Signal SIG1 und dem zweiten Signal SIG2. Dabei wird das erste Signal SIG1 basierend auf der dem ersten Signal zugeordneten Funktionalität und den Werten der Parameter P1, P2, P3 der Funktionalität erzeugt. Das zweite Signal SIG2 wird basierend auf der dem zweiten Signal zugeordneten Funktionalität und den Werten der Parameter P4.P5 der Funktionalität erzeugt. Die erste Nachricht MES1 wird dann über die Signalleitung BUS versendet. Ebenso erzeugt das erste Steuergerät ECU1 die zweite Nachricht MES2 mit dem dritten Signal SIG3 und dem vierten Signal SIG4, basierend auf der dem dritten Signal SIG3 zugeordneten Funktionalität und der dem vierten Signal SIG4 zugeordneten Funktionalität und versendet die zweite Nachricht MES2 über die Signalleitung BUS. Das zweite Steuergerät erzeugt die dritte Nachricht MES3 mit dem fünften Signal SIG5 basierend auf der dem fünften Signal SIG5 zugeordneten Funktionalität und die vierte Nachricht MES4 mit dem sechsten Signal SIG6 basierend auf der dem sechsten Signal SIG6 zugeordneten Funktionalität. Das zweite Steuergerät versendet die dritte Nachricht MES3 und die vierte Nachricht MES4 über die Signalleitung BUS an das erste Steuergerät.

Es versteht sich, dass das Verfahren auf beliebig viele Steuergeräte, Nachrichten, Signale, Funktionalitätsklassen, Parameter und Kategorien erweitert werden kann.

## Patentansprüche

1. Verfahren zur Konfiguration von zumindest einer ersten Funktionalität von realen und/oder simulierten Steuergeräten (ECU1, ECU2),
- wobei die erste Funktionalität als eine Instanz einer ersten Funktionalitätsklasse (F1, F2) gegeben ist,
- wobei die erste Funktionalität mindestens eine von der ersten Funktionalitätsklasse (F1, F2) abhängige Funktion und mindestens einen von der ersten Funktionalitätsklasse (F1, F2) abhängigen ersten
Parameter (P1, P2, P3, P4, P5, P6) umfasst,
- wobei die erste Funktionalität mindestens einem Steuergerät (ECU1, ECU2) zugeordnet wird, wobei das mindestens eine Steuergerät (ECU1, ECU2) mit der ihm zugeordneten ersten Funktionalität mit der mindestens einen Funktion und dem Wert des mindestens einen ersten Parameters (P1, P2, P3, P4, P5, P6) der ersten Funktionalität konfiguriert wird, wobei
- die erste Funktionalitätsklasse (F1, F2) Kategorien aufweist zur Zuordnung der ersten Funktionalität zu einer ersten Kategorie,
- wobei die Kategorien
mindestens eine erste Default-Kategorie (K1, K2, K3, K4) aufweisen,
- wobei die Funktionalitäten der ersten Funktionalitätsklasse (F1, F2) jeweils einer Kategorie (K1, K2, K3, K4, ELSE) angehören,
- wobei für die erste Default-Kategorie (K1, K2, K3, K4) für den mindestens einen ersten Parameter (P1, P2, P3, P4, P5, P6) ein erster vorbestimmter Wert (V1, V2, V3, V4) hinterlegt ist und bei der Zuordnung der ersten Funktionalität zu der ersten Default-Kategorie (K1, K2, K3, K4) für den mindestens einen ersten Parameter (P1, P2, P3, P4, P5, P6) der erste vorbestimmte Wert (V1, V2, V3, V4) übernommen wird,
**dadurch gekennzeichnet, dass**
die Konfiguration der ersten Funktionalität für die Kommunikation zwischen realen und/oder simulierten Steuergeräten (ECU1, ECU2) erfolgt, wobei die erste Funktionalität dem mindestens einen Steuergerät (ECU1, ECU2) direkt zugeordnet wird oder indirekt über ein Signal (SIG1, SIG2, SIG3, SIG4, SIG5, SIG6), eine Protocol Data Unit (PDU) oder eine Nachricht (MES1, MES2, MES3, MES4) zugeordnet wird, und dass die Kategorien eine ELSE-Kategorie (ELSE) aufweisen, wobei die ELSE-Kategorie (ELSE) keine vorbestimmten Werte für den mindestens einen ersten Parameter (P1, P2, P3, P4, P5, P6) aufweist und wobei die Funktionalitäten der ersten Funktionalitätsklasse (F1, F2), die keiner Default-Kategorie (K1, K2, K3, K4) zugeordnet sind, automatisch der ELSE-Kategorie (ELSE) zugeordnet werden, und dass bei einer Änderung des ersten vorbestimmten Werts (V1, V2, V3, V4) des ersten Parameters (P1, P2, P3, P4, P5, P6) der ersten Default-Kategorie (K1, K2, K3, K4) die Änderung für alle bereits der ersten Default-Kategorie (K1, K2, K3, K4) zugeordneten Funktionalitäten übernommen wird

2. Verfahren nach Anspruch 1, **dadurch gekennzeichnet, dass** die erste Funktionalitätsklasse (F1, F2) eine zweite Default-Kategorie (K1, K2, K3, K4) aufweist, wobei für die zweite Default-Kategorie (K1, K2, K3, K4) für den mindestens einen ersten Parameter (P1, P2, P3, P4, P5, P6) ein zweiter vorbestimmter Wert (V1, V2, V3, V4) hinterlegt ist und bei der Zuordnung der Funktionalität zu der zweiten Default-Kategorie (K1, K2, K3, K4) für den mindestens einen ersten Parameter (P1, P2, P3, P4, P5, P6) der zweite vorbestimmte Wert (V1, V2, V3, V4) übernommen wird, wobei bei einer Änderung des zweiten vorbestimmten Werts (V1, V2, V3, V4) des ersten Parameters (P1, P2, P3, P4, P5, P6) der zweiten Default-Kategorie (K1, K2, K3, K4) die Änderung für alle bereits der zweiten Default-Kategorie (K1, K2, K3, K4) zugeordneten Funktionalitäten übernommen wird.

3. Verfahren nach Anspruch 1 oder 2, **dadurch gekennzeichnet, dass** die Steuergeräte an ein gemeinsames Netzwerk angeschlossen sind.

4. Verfahren nach einem der Ansprüche 1 bis 3, **dadurch gekennzeichnet, dass** die Funktionalität aus einer Netzwerkbeschreibungsdatei ausgelesen wird

5. Verfahren nach einem der Ansprüche 1 bis 4, **dadurch gekennzeichnet, dass** die die vorbestimmten Werte (V1, V2, V3, V4) aus einer Netzwerkbeschreibungsdatei ausgelesen werden.

6. Verfahren nach einem der vorstehenden Ansprüche, **dadurch gekennzeichnet, dass** die erste Funktionalität durch die Zuordnung zu einer Default-Kategorie (K1, K2, K3, K4) um eine zusätzliche Funktion und/oder einen zusätzlichen Parameter erweitert wird.

7. Verfahren nach einem der vorstehenden Ansprüche, **dadurch gekennzeichnet, dass** eine der ersten Funktionalitätsklasse zugeordnete dritte Funktionalität automatisch der ersten Default-Kategorie (K1, K2, K3, K4) zugeordnet wird, wenn nach einer individuellen Änderung eines Werts eines Parameters (P1, P2, P3, P4, P5, P6) der dritten Funktionalität die Werte aller Parameter (P1, P2, P3, P4, P5, P6) der dritten Funktionalität mit den jeweiligen vorbestimmten Werten (V1, V2, V3, V4) der ersten Default-Kategorie (K1, K2, K3, K4) übereinstimmen.

8. Verfahren nach einem der vorstehenden Ansprüche, **dadurch gekennzeichnet, dass** eine vierte Funktionalität automatisch der Else-Kategorie (ELSE) zugeordnet wird, wenn ein Wert eines Parameters (P1, P2, P3, P4, P5, P6) der vierten Funktionalität individuell geändert wird und keine Default-Kategorie (K1, K2, K3, K4) vorhanden ist, deren vorbestimmte Werte (V1, V2, V3, V4) den Parameterwerten der vierten Funktionalität entsprechen.

9. Verfahren nach einem der vorstehenden Ansprüche, **dadurch gekennzeichnet, dass** eine dritte Default-Kategorie (K1, K2, K3, K4) aus einer zweiten Funktionalität der ersten Funktionalitätsklasse (F1, F2) erzeugt wird, indem die zweite Funktionalität ausgewählt wird und der Wert des mindestens einen Parameters (P1, P2, P3, P4, P5, P6) der zweiten Funktionalität als vorbestimmter Wert (V1, V2, V3, V4) für die dritte Default-Kategorie (K1, K2, K3, K4) hinterlegt wird.

10. Verfahren nach einem der vorstehenden Ansprüche, **dadurch gekennzeichnet, dass** die Funktionalität einer von dem zugeordneten Steuergerät zu versendenden oder zu empfangenden Nachricht (MES1, MES2, MES3, MES4) oder PDU zugeordnet wird.

11. Verfahren nach einem der vorstehenden Ansprüche, **dadurch gekennzeichnet, dass** die Funktionalität einem von dem zugeordneten Steuergerät zu versendenden oder empfangenden Signal (SIG1, SIG2, SIG3, SIG4, SIG5, SIG6) zugeordnet wird.

12. Verfahren nach einem der vorstehenden Ansprüche, **dadurch gekennzeichnet, dass** die erste Funktionalität einen zweiten Parameter umfasst, wobei in der ersten Default-Kategorie (K1, K2, K3, K4, K4) für den zweiten Parameter (P1, P2, P3, P4, P5, P6) kein vorbestimmter Wert (V1, V2, V3, V4) hinterlegt ist, wobei der Wert des zweiten Parameters(P1, P2, P3, P4, P5, P6) bei der Zuordnung der Funktionalität zur ersten Default-Kategorie (K1, K2, K3, K4) unverändert bleibt.

13. Datenverarbeitungseinrichtung mit einer Prozessoreinheit, wobei die Datenverarbeitungseinrichtung zur Durchführung des Verfahrens nach einem der vorhergehenden Ansprüche ausgeführt ist.

14. Computerprogrammprodukt mit Computer-implementierten Anweisungen, das nach dem Laden und Ausführen in einer geeigneten Datenverarbeitungseinrichtung die Schritte des Verfahrens nach einem der Ansprüche 1 bis 12 ausführt.

15. Digitales Speichermedium mit elektronisch auslesbaren Steuersignalen, die so mit einer programmierbaren Datenverarbeitungseinrichtung zusammenwirken können, dass das Verfahren nach einem der Ansprüche 1 bis 12 auf der Datenverarbeitungseinrichtung ausgeführt wird.

## Claims

1. A method for configuring at least one first functionality of real and/or simulated control devices (ECU1, ECU2),
- the first functionality being given as an instance of a first functionality class (F1, F2),
- the first functionality comprising at least one function depending on the first functionality class (F1, F2) and at least one first parameter (PI, P2, P3, P4, P5, P6) depending on the first functionality class (F1, F2),
- the first functionality being associated with at least one control device (ECU1, ECU2), the at least one control device (ECU1, ECU2) being configured by means of the first functionality associated therewith having the at least one function, and by means of the value of the at least one first parameter (P1, P2, P3, P4, P5, P6) of the first functionality,
- the first functionality class (F1, F2) comprising categories for associating the first functionality with a first category,
- the categories comprising at least one first default category (K1, K2, K3, K4),
- the functionalities of the first functionality class (F1, F2) each belonging to one category (K1, K2, K3, K4, ELSE),
- a first predetermined value (V1, V2, V3, V4) being saved for the at least one first parameter (P1, P2, P3, P4, P5, P6) for the first default category (K1, K2, K3, K4), and the first predetermined value (V1, V2, V3, V4) being applied to the at least one first parameter (P1, P2, P3, P4, P5, P6) when associating the first functionality with the first default category (K1, K2, K3, K4),
**characterized in that**
- the configuration of the first functionality is done for communicating between real and/or simulated control devices (ECU1, ECU2), wherein the first functionality is directly associated with the at least one control device (ECU1, ECU2) or indirectly associated by means of a signal (SIG1, SIG2, SIG3, SIG4, SIG5, SIG6), a protocol data unit (PDU) or a message (MES1, MES2, MES3, MES4), and that the categories comprise an ELSE category (ELSE), wherein the ELSE category (ELSE) does not comprise predetermined values for the at least one first parameter (P1, P2, P3, P4, P5, P6), and wherein the functionalities of the first functionality class (F1, F2) not associated with any default category (K1, K2, K3, K4) are automatically associated with the ELSE category (ELSE), and that for a change to the first predetermined value (V1, V2, V3, V4) of the first parameter (P1, P2, P3, P4, P5, P6) of the first default category (K1, K2, K3, K4), said change is applied to all functionalities already associated with the first default category (K1, K2, K3, K4).

2. The method according to claim 1, **characterized in that** the first functionality class (F1, F2) comprises a second default category (K1, K2, K3, K4), wherein a second predetermined value (V1, V2, V3, V4) is saved for the at least one first parameter (P1, P2, P3, P4, P5, P6) for the second default category (K1, K2, K3, K4), and the second predetermined value (V1, V2, V3, V4) is applied to the at least one first parameter (P1, P2, P3, P4, P5, P6) when associating the functionality with the second default category (K1, K2, K3, K4), wherein for a change to the second predetermined value (V1, V2, V3, V4) of the first parameter (P1, P2, P3, P4, P5, P6) of the second default category (K1, K2, K3, K4), said change is applied to all functionalities already associated with the second default category (K1, K2, K3, K4).

3. The method according to claim 1 or 2, **characterized in that** the control devices are connected to a common network.

4. The method according to any one of the claims 1 through 3, **characterized in that** the functionality is read from a network description file.

5. The method according to any one of the claims 1 through 4, **characterized in that** the predetermined values (V1, V2, V3, V4) are read from a network description file.

6. The method according to any one of the preceding claims, **characterized in that** by association with a default category (K1, K2, K3, K4), the first functionality is expanded by an additional function and/or an additional parameter.

7. The method according to any one of the preceding claims, **characterized in that** a third functionality associated with the first functionality class is automatically associated with the first default category (K1, K2, K3, K4) if, after an individual change to a value of a parameter (P1, P2, P3, P4, P5, P6) of the third functionality, the values of all parameters (P1, P2, P3, P4, P5, P6) of the third functionality match the predetermined values (V1, V2, V3, V4) of the first default category (K1, K2, K3, K4) in each case.

8. The method according to any one of the preceding claims, **characterized in that** a fourth functionality is automatically associated with the ELSE category (ELSE) if a value of a parameter (P1, P2, P3, P4, P5, P6) of the fourth functionality is individually changed and no default category (K1, K2, K3, K4) is present having predetermined values (V1, V2, V3, V4) corresponding to the parameter values of the fourth functionality.

9. The method according to any one of the preceding claims, **characterized in that** a third default category (K1, K2, K3, K4) is generated from a second functionality of the first functionality class (F1, F2) **in that** the second functionality is selected and the value of the at least one parameter (P1, P2, P3, P4, P5, P6) of the second functionality is saved as a predetermined value (V1, V2, V3, V4) for the third default category (K1, K2, K3, K4).

10. The method according to any one of the preceding claims, **characterized in that** the functionality is associated with a message (MES1, MES2, MES3, MES4) for sending or for receiving by the associated control device or with a PDU.

11. The method according to any one of the preceding claims, **characterized in that** the functionality is associated with a signal (SIG1, SIG2, SIG3, SIG4, SIG5, SIG6) for sending or for receiving by the associated control device.

12. The method according to any one of the preceding claims, **characterized in that** the first functionality comprises a second parameter, wherein no predetermined value (V1, V2, V3, V4) is saved in the first default category (K1, K2, K3, K4) for the second parameter (PI, P2, P3, P4, P5, P6), wherein the value of the second parameter (P1, P2, P3, P4, P5, P6) remains unchanged when associating the functionality with the first default category (K1, K2, K3, K4).

13. A data processing device having a processor unit, the data-processing device being implemented for performing the method according to any one of the preceding claims.

14. A computer program product having computer-implemented instructions and executing the steps of the method according to any one of the claims 1 through 12 after loading and executing in a suitable data-processing device.

15. A digital storage medium having electronically readable control signals able to interact with a programmable data-processing device such that the method according to any one of the claims 1 through 12 is executed on the data-processing device.

## Revendications

1. Procédé pour configurer au moins une première fonctionnalité d'appareils de commande (ECU1, ECU2) réels et/ou simulés,
- dans lequel la première fonctionnalité est donnée en tant qu'instance d'une première classe de fonctionnalité (F1, F2),
- dans lequel la première fonctionnalité comprend au moins une fonction dépendant de la première classe de fonctionnalité (F1, F2) et au moins un premier paramètre (P1, P2, P3, P4, P5, P6) dépendant de la première classe de fonctionnalité (F1, F2),
- dans lequel la première fonctionnalité est affectée à au moins un appareil de commande (ECU1, ECU2), dans lequel l'au moins un appareil de commande (ECU1, ECU2) est configuré avec la première fonctionnalité qui lui est affectée, avec l'au moins une fonction et la valeur de l'au moins un premier paramètre (P1, P2, P3, P4, P5, P6) de la première fonctionnalité, sachant que
- la première classe de fonctionnalité (F1, F2) présente des catégories pour affecter la première fonctionnalité à une première catégorie,
- sachant que les catégories présentent au moins une première catégorie par défaut (K1, K2, K3, K4),
- sachant que les fonctionnalités de la première classe de fonctionnalité (F1, F2) appartiennent respectivement à une catégorie (K1, K2, K3, K4, ELSE),
- sachant que pour la première catégorie par défaut (K1, K2, K3, K4), pour l'au moins un premier paramètre (P1, P2, P3, P4, P5, P6), une première valeur prédéterminée (V1, V2, V3, V4) est stockée et, lors de l'affectation de la première fonctionnalité à la première catégorie par défaut (K1, K2, K3, K4), pour l'au moins un premier paramètre (P1, P2, P3, P4, P5, P6), la première valeur prédéterminée (V1, V2, V3, V4) est reprise,
**caractérisé en ce que**
- la configuration de la première fonctionnalité est effectuée pour la communication entre des appareils de commande (ECU1, ECU2) réels et/ou simulés, sachant que la première fonctionnalité est affectée directement à l'au moins un appareil de commande (ECU1, ECU2) ou affectée indirectement via un signal (SIG1, SIG2, SIG3, SIG4, SIG5, SIG6), une Unité de Données de Protocole (UDP) ou un message (MES1, MES2, MES3, MES4), et **en ce que** les catégories présentent une catégorie ELSE (ELSE), sachant que la catégorie ELSE (ELSE) ne présente pas de valeurs prédéterminées pour l'au moins un premier paramètre (P1, P2, P3, P4, P5, P6) et sachant que les fonctionnalités de la première classe de fonctionnalité (F1, F2), qui ne sont affectées à aucune catégorie par défaut (K1, K2, K3, K4), sont automatiquement affectées à la catégorie ELSE (ELSE), et **en ce que**, en cas de modification de la première valeur prédéterminée (V1, V2, V3, V4) du premier paramètre (P1, P2, P3, P4, P5, P6) de la première catégorie par défaut (K1, K2, K3, K4), la modification est reprise pour toutes les fonctionnalités déjà affectées à la première catégorie par défaut (K1, K2, K3, K4).

2. Procédé selon la revendication 1, **caractérisé en ce que** la première classe de fonctionnalité (F1, F2) présente une seconde catégorie par défaut (K1, K2, K3, K4), sachant que pour la seconde catégorie par défaut (K1, K2, K3, K4), une seconde valeur prédéterminée (V1, V2, V3, V4) est stockée pour l'au moins un premier paramètre (P1, P2, P3, P4, P5, P6) et que la seconde valeur prédéterminée (V1, V2, V3, V4) est reprise pour l'au moins un premier paramètre (P1, P2, P3, P4, P5, P6) lors de l'affectation de la fonctionnalité à la seconde catégorie par défaut (K1, K2, K3, V4), sachant qu'en cas de modification de la seconde valeur prédéterminée (V1, V2, V3, V3, V3, V4) du premier paramètre (P1, P2, P3, P4, P5, P6) de la seconde catégorie par défaut (K1, K2, K3, K4), la modification est reprise pour toutes les fonctionnalités déjà affectées à la seconde catégorie par défaut (K1, K2, K3, K4).

3. Procédé selon la revendication 1 ou 2, **caractérisé en ce que** les appareils de commande sont connectés à un réseau commun.

4. Procédé selon l'une quelconque des revendications 1 à 3, **caractérisé en ce que** la fonctionnalité est extraite par lecture depuis un fichier de description de réseau.

5. Procédé selon l'une quelconque des revendications 1 à 4, **caractérisé en ce que** les valeurs prédéterminées (V1, V2, V3, V4) sont extraites par lecture depuis un fichier de description de réseau.

6. Procédé selon l'une quelconque des revendications précédentes, **caractérisé en ce que** la première fonctionnalité est étendue d'une fonction supplémentaire et/ou d'un paramètre supplémentaire par l'affectation à une catégorie par défaut (K1, K2, K3, K4).

7. Procédé selon l'une quelconque des revendications précédentes, **caractérisé en ce qu'**une troisième fonctionnalité affectée à la première classe de fonctionnalité est automatiquement affectée à la première catégorie par défaut (K1, K2, K3, K4) si, après une modification individuelle d'une valeur d'un paramètre (P1, P2, P3, P4, P5, P6) de la troisième fonctionnalité, les valeurs de tous les paramètres (P1, P2, P3, P4, P5, P6) de la troisième fonctionnalité correspondent aux valeurs prédéterminées (V1, V2, V3, V4) respectives de la première catégorie par défaut (K1, K2, K3, K4).

8. Procédé selon l'une quelconque des revendications précédentes, **caractérisé en ce qu'**une quatrième fonctionnalité est automatiquement affectée à la catégorie Else (ELSE) si une valeur d'un paramètre (P1, P2, P3, P4, P5, P6) de la quatrième fonctionnalité est modifiée individuellement et qu'il n'existe aucune catégorie par défaut (K1, K2, K3, K4) dont les valeurs prédéterminées (V1, V2, V3, V4) correspondent aux valeurs de paramètres de la quatrième fonctionnalité.

9. Procédé selon l'une quelconque des revendications précédentes, **caractérisé en ce qu'**une une troisième catégorie par défaut (K1, K2, K3, K4) est générée à partir d'une seconde fonctionnalité de la première classe de fonctionnalité (F1, F2) en ce sens que la seconde fonctionnalité est sélectionné et la valeur de l'au moins un paramètre (P1, P2, P3, P4, P5, P6) de la seconde fonctionnalité est stockée en tant que valeur prédéterminée (V1, V2, V3, V4) pour la troisième catégorie par défaut (K1, K2, K3, K4).

10. Procédé selon l'une quelconque des revendications précédentes, **caractérisé en ce que** la fonctionnalité est affectée à un message (MES1, MES2, MES3, MES4) ou UDP devant être envoyé ou reçu par l'appareil de commande affecté.

11. Procédé selon l'une quelconque des revendications précédentes, **caractérisé en ce que** la fonctionnalité est affectée à un signal (SIG1, SIG2, SIG3, SIG4, SIG5, SIG6) devant être envoyé ou reçu par l'appareil de commande affecté.

12. Procédé selon l'une quelconque des revendications précédentes, **caractérisé en ce que** la première fonctionnalité comprend un second paramètre, sachant que dans la première catégorie par défaut (K1, K2, K3, K4, K4, K4) pour le second paramètre (P1, P2, P3, P4, P5, P6), aucune valeur prédéterminée (V1, V2, V3, V4) n'est stockée, sachant que la valeur du second paramètre (P1, P2, P3, P4, P5, P6) reste inchangée lors de l'affectation de la fonctionnalité à la première catégorie par défaut (K1, K2, K3, K4).

13. Dispositif de traitement de données avec une unité de processeur, dans lequel le dispositif de traitement de données est réalisé pour exécuter le procédé selon l'une quelconque des revendications précédentes.

14. Produit de programme informatique avec des instructions implémentées sur ordinateur, qui, après le chargement et le lancement dans un dispositif de traitement de données approprié, exécute les étapes du procédé selon l'une quelconque des revendications 1 à 12.

15. Support de stockage numérique avec des signaux de commande lisibles électroniquement, qui peuvent coopérer avec un dispositif de traitement de données programmable de sorte que le procédé selon l'une quelconque des revendications 1 à 12 soit exécuté sur le dispositif de traitement de données.
